Europäisches Patentamt

European Patent Office

Office européen des brevets

(11) Veröffentlichungsnummer: **0 273 251 B1**

(12) **EUROPÄISCHE PATENTSCHRIFT**

(45) Veröffentlichungstag der Patentschrift: 20.03.91

(51) Int. Cl.5: **C23C 14/54**, G01R 27/02, H01L 21/66

(21) Anmeldenummer: 87118187.1

(22) Anmeldetag: 08.12.87

(54) Verfahren zur Steuerung und Kontrolle von durch im Plasma aktivierte Ionen, Radikale und/oder neutrale Teilchen bewirkten Ätzprozessen, insbesondere für höchstintegrierte Halbleiterschaltungen.

(30) Priorität: 11.12.86 DE 3642379

(43) Veröffentlichungstag der Anmeldung:
06.07.88 Patentblatt 88/27

(45) Bekanntmachung des Hinweises auf die Patenterteilung:
20.03.91 Patentblatt 91/12

(84) Benannte Vertragsstaaten:
AT CH DE FR GB IT LI NL SE

(56) Entgegenhaltungen:
EP-A- 0 067 432
EP-A- 0 154 696
US-A- 4 245 154

SIEMENS FORSCHUNGS- UND ENTWICK-LUNGSBERICHTE, Band 11, Nr. 6, 1982, Seiten 322-326, Würzburg; N.M. MAYER "Resistance measurements by radio telemetric system during film deposition by sputtering"

IBM TECHNICAL DISCLOSURE BULLETIN,

Band 22, Nr. 6, November 1979, Seiten 2513-2514; N.J. CHOW "Technique for in-situ or real-time monitoring of contact hole etching in silicon technology"

idem

(73) Patentinhaber: Siemens Aktiengesellschaft
Wittelsbacherplatz 2
W-8000 München 2(DE)

(72) Erfinder: Hieber, Konrad, Dr.rer.nat.
Laubensteinstrasse 7
W-8214 Bernau(DE)

## Beschreibung

Die Erfindung betrifft ein Verfahren zur Steuerung und Kontrolle von durch im Plasma aktivierte Ionen, Radikale und neutrale Teilchen bewirkten Ätzprozessen, wie sie insbesondere bei der Strukturierung von für höchstintegrierte Halbleiterschaltungen verwendete elektrisch leitende Dünnschichten mit Photolackmaskierung verwendet werden.

Die gezielte und maßgetreue Strukturierung dünner Schichten durch im Plasma aktivierte Ionen, Radikale und/oder neutrale Teilchen bewirkte Ätzprozesse (sogenanntes Trockenätzen) ist ein kritischer Prozeßschritt bei der Herstellung höchstintegrierter Halbleiterbauelemente, wie aus dem Buch, VLSI-Technology von S. M. Sze, Mc-Graw-Hill, Int. Book Comp. (1984) im Kapitel "Dry Etching", insbesondere auf den Seiten 305, 306 und 307 zu entnehmen ist.

Bei dem sogenannten Trockenätzverfahren befindet sich auf der zu strukturierenden Schicht bzw. auf dem zu strukturierenden Substrat bereits eine strukturierte Schicht aus Photolack. Das Problem besteht nun darin, die Struktur des Photolacks in die darunterliegende Schicht bzw. in das Substrat (zum Beispiel aus einkristallinem Silizium) maßgetreu zu übertragen. Dazu wird das lokal mit Photolack beschichtete Substrat mit geeigneten Ionen beschossen bzw. in ein Plasma eingebracht. Die im Plasma chemisch aktivierten Teilchen (Ionen und Neutrale) reagieren mit dem freiliegenden Schicht- bzw. Substratmaterial unter Bildung einer flüchtigen Verbindung derart, daß ein lokaler Materialabtrag erfolgt. Der lokale Materialabtrag kann auch durch einfache Stoßprozesse der Atome, Ionen oder Moleküle (Zerstäuben bzw. Sputtern) unterstützt werden.

Bei der Entwicklung von Ätzprozessen ist darauf zu achten, daß die Reaktivität des Plasmas durch geeignete Wahl der Ausgangsgase derart gewählt wird, daß die Abtragrate für den Photolack bzw. für das unter der zu strukturierenden Schicht liegende Material möglichst gering ist. Dies bedeutet, daß für jedes Schichtmaterial ein eigener Ätzprozeß entwickelt werden muß. Da ferner eine extrem hohe Reproduzierbarkeit für die geringen maßlichen Toleranzen (zum Beispiel ± 0,1 µm) gefordert wird, müssen die Prozesse ständig überwacht werden.

Aufgabe der Erfindung ist es daher, ein Kontroll- und auch Steuerungsverfahren anzugeben, mit dem es möglich ist, diese Bedingungen zu erfüllen.

Bisher wurden zur Ermittlung der Ätzrate bzw. des Endpunktes der Ätzung hauptsächlich spektrometrische Verfahren zur Charakterisierung des Plasmas verwendet (siehe S. M. Sze, VLSI-Technology, Mc-Graw-Hill, Int. Book Comp. (1984), Seite 334). Dabei ist es wesentlich, im Plasma die Emissions- oder Absorptionslinie eines Moleküls zu finden, die für den jeweiligen Ätzprozeß charakteristisch ist. Die Intensität dieser Linie nimmt rasch ab, wenn das zu ätzende Material vollständig beseitigt ist. Aus der Zeit bis zur Intensitätsabnahme läßt sich - bei bekannter Schichtdicke - die Ätzrate errechnen. Es ist dabei offensichtlich, daß bei diesen Verfahren über das Ätzverhalten aller Scheiben in der Anlage gemittelt wird. Für die lokale Bestimmung der Ätzrate müssen Proben entnommen werden, um den Materialabtrag zum Beispiel im Rasterelektronenmikroskop zu ermitteln. Eine lokale Charakterisierung des Plasmas ist sehr schwierig, da durch die notwendigen Sonden (zum Beispiel Langmuir-Sonden) das Plasma selbst zu stark beeinflußt wird (nähere Einzelheiten siehe Aufsatz von Clements im J. Vac. Sci. Technol. 15 (2) März/April 1978, Seiten 193-198).

Die Erfindung beschreitet einen anderen Weg zur Lösung der Aufgabe einer reproduzierbaren Kontrolle von Trockenätzprozessen und löst damit auch das Problem, direkt in den Prozeß steuernd einzugreifen.

Es handelt sich dabei um ein Verfahren der eingangs genannten Art durch Bestimmung der Ätzrate und des Endpunktes der auf einem Substrat befindlichen zu ätzenden Schicht während des Materialabtrags im Plasma unter Verwendung eines Referenzsubstrates mit niederohmigen Kontakten und Messung des elektrischen Widerstandes in Abhängigkeit von der Schichtdicke, bei dem als Ätzreaktor ein evakuierter Rezipient mit einer evakuierbaren Schleusenkammer verwendet wird, der die zu ätzenden Substrate tragende Substrathalter beweglich ausgebildet ist, die Meßdaten berührungsfrei durch elektromagnetische Strahlung im Pulscodemodulationsverfahren (PCM-Verfahren) übertragen werden, wobei ein telemetrisches Meßsystem verwendet wird, welches als unabhängige Einheit an dem beweglichen Substrathalter montiert ist, und bei dem ein Referenzsubstrat verwendet wird, welches entsprechend der Größe der in der leitenden Schicht zu strukturierenden Bereiche unterschiedlich große Photolackmaskierungsbereiche enthält, die elektrisch vermessen werden, so daß die Ätzrate und die Schichtdickenabnahme aus dem zeitlichen Verlauf der Widerstandszunahme des Flächenwiderstandes kontrolliert und damit der Endpunkt der Ätzung bestimmt werden kann.

Dabei liegt es im Rahmen der Erfindung, daß der Flächenwiderstand gemessen wird und aus dem zeitlichen Verlauf der Widerstandszunahme die Schichtdickenabnahme kontrolliert und damit auch der Endpunkt der Ätzung bestimmt wird.

Eine solche, in situ durchgeführte Widerstandsmessung, aber für den Aufbau einer Schicht durch Aufdampfen oder Aufstäuben (Sputtern), ist bereit in der europäischen Patentschrift 0 067 432 beschrieben worden.

Aus der europäichen Patentanmeldung 0 154 696 it ein Verfahren zur Kontrolle und Regelung der Zusammensetzung und der Schichtdicke von metallisch leitenden Legierungsschichten bekannt, bei dem ebenfalls während der Herstellung der Schicht der elektrische Widerstand gemessen wird. Durch Vergleich der gemessenen Istwerte des Schichtwiderstandes jeder einzelnen Legierungskomponentenlage mit den vor der Schichtherstellung festgelegten Sollwerten werden die Beschichtungsraten der entsprechenden Legierungskomponenten gesteuert.

Die Erfindung macht sich diese Erkenntnis zunutze und steuert bzw. kontrolliert den Abtrag einer elektrisch leitenden Schicht, das heißt die Ätzrate bzw. deren Zeitabhängigkeit einschließlich des Endpunktes. Dabei ist es hier für die Steuerung von Bedeutung, daß die Ätzrate beeinflußt wird von

a) dem Gesamtdruck des Ätzsystems,
b) der HF-Leistung bei der Plasmaerzeugung,
c) der Ionen-Energie,
d) der Gaszusammensetzung,
e) dem Vorhandensein von Restgasen in der Anlage und
f) von der Größe der zu strukturierenden Bereiche.

Die Abhängigkeit der Ätzrate von der Größe der zu strukturierenden Bereiche läßt sich kontrollieren, wenn gemäß einem Ausführungsbeispiel nach der Lehre der Erfindung auf dem Referenzsubstrat unterschiedlich große Photolackmaskierungsbereiche erzeugt, anschließend trockengeätzt und elektrisch vermessen werden.

Im folgenden wird die Erfindung anhand von Ausführungsbeispielen und der Figuren 1 bis 6 noch näher erläutert. Dabei zeigen

die Figur 1 in einem Kurvendiagramm die Abhängigkeit des Flächenwiderstandes $R_F$ von der Schichtdicke d der zu ätzenden metallischen Schicht,

die Figuren 2 und 4 das für die Messung vorgesehene Referenzsubstrat mit Meßkontakten in Draufsicht, wobei Figur 2 eine fein strukturierte Photolackschicht und Figur 4 eine grob strukturierte Photolackschicht enthält,

die Figuren 3 und 5 die entsprechenden Schnittbilder zu Figur 2 und 4 und

die Figur 6 den funktionellen Zusammenhang des Meßsystems und seine Anordnung in bzw. zu der Ätzanlage.

In allen Figuren sind gleiche Teile mit gleichen Bezugzeichen versehen.

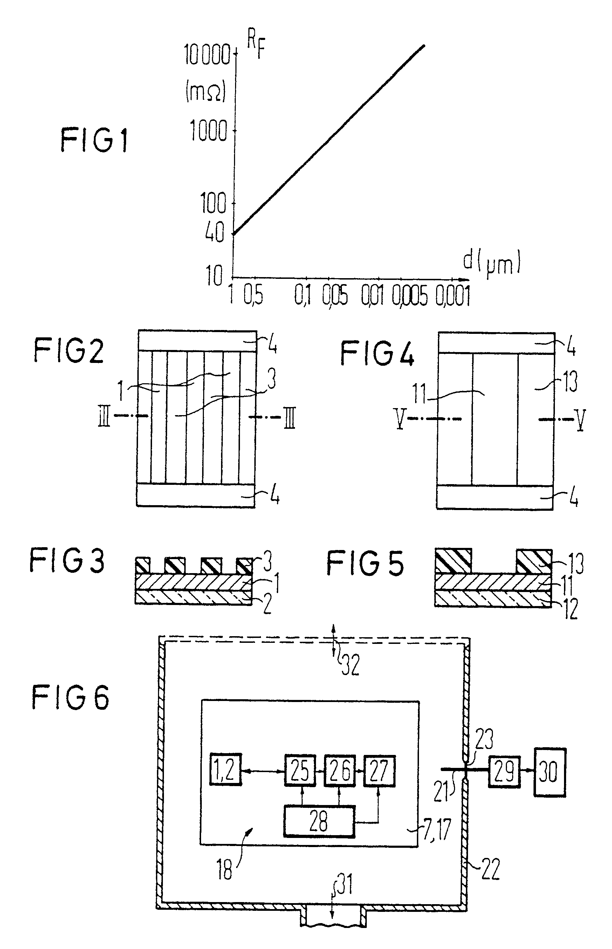

In Figur 1 ist die Zunahme des Flächenwiderstandes $R_F$ (mOhm) beim Ätzen einer Aluminium-Silizium-Legierungsschicht in Abhängigkeit von der verbleibenden Schichtdicke d ($\mu$m) aufgetragen.

Der Flächenwiderstand $R_F$ errechnet sich aus dem Quotienten spezifischer elektrischer Widerstand zur Schichtdicke. Bei einem spezifischen elektrischen Widerstand für eine Aluminium-Silizium-Legierung (1 % Silizium) von zum Beispiel 4 $\mu$Ohmcm ergibt sich in doppelt logarithmischer Darstellung, wie Figur 1 zeigt, eine Gerade.

Die Messungen werden wie folgt durchgeführt: Auf eine Referenzsubstratscheibe (siehe Figuren 2 bis 5) wird die zu strukturierende Schicht völlig analog zu den für die Herstellung der integrierten Schaltung vorgesehenen Halbleiterkristallscheiben aufgebracht. Nun wird die gesamte oder ein Teilbereich der Referenzsubstratscheibe in das Telemetriesystem (siehe Figur 6) eingebaut und elektrisch kontaktiert. Das Meßsystem wird jetzt einen bestimmten Flächenwiderstand $R_F$ anzeigen. Für eine bestimmte, zum Beispiel 1 $\mu$m dicke Aluminium-Silizium (1 %)-Schicht liegt dieser Wert bei ca. 40 mOhm. Mit einsetzendem Ätzprozeß wird die Schicht immer dünner, das heißt, der Flächenwiderstand $R_F$ steigt stark an.

Aus dem Kurvenverlauf in Figur 1 ist ersichtlich, daß gerade im interessanten Bereich, das heißt, kurz vor der vollständigen Entfernung der Schicht, die höchste Widerstandsänderung erreicht wird. Da das Telemetriesystem in der Anlage genauso bewegt wird wie die zur Bearbeitung anstehenden Halbleiterkristallscheiben, erhält man aus dem zeitlichen Verlauf der Widerstandszunahme auch die Information über zeitliche und örtliche Schwankungen.

Die Figuren 2 bis 5 zeigen das für die Messung verwendete Referenzsubstrat, wobei folgende Bezugzeichen gelten:

1 = abzutragende Aluminium-Silizium (1 %)-Legierungsschicht,
2 = elektrisch isoliertes Substrat,
3 = feinstrukturierte Photolackschicht,
4 = niederohmige Kontaktelektroden für die Messung,
13 = grobstrukturierte Photolackschicht.

Um eine eventuelle Abhängigkeit der Ätzrate von der Größe der zu strukturierenden Bereiche zu ermitteln, werden auf dem Referenzsubstrat unterschiedlich große Lackstrukturen erzeugt, anschließend geätzt und elektrisch vermessen. Ist die Summe der Breite der schmalen Aluminiumstege 1 in Figur 2 und 3 gleich der Breite des breiten Aluminiumsteges 11 in Figur 4 und 5, so kann bei unterschiedlichem Verlauf der Widerstandszunahme beim Ätzen direkt auf einen Unterschied in der Ätzrate geschlossen werden.

Bezüglich Figur 6 wird auf die in dem europäischen Patent 0 067 432 dargestellte Anordnung verwiesen. Wie aus der Figur 6 zu entnehmen ist, stellt das in eine Doppelpalette 7, 17 eingebaute Meßsystem 18 mit dem Sender 27 ein unabhängiges System dar. Die Meßdatenübertragung von der rotierenden Palette 7, 17 erfolgt über das Telemetriesystem, wobei sich der Umsetzer, der die Meßspannung, die an der Schicht 1, 2 gemessen worden ist, in übertragungsfähige Puls-Code-Modulations-Signale verwandelt unter der Palette befindet. Die Meßapparatur (18) einschließlich Sender 27 wird mit einer Batterie 28 betrieben. Die Empfangsantenne 21 wird bei Verwendung von HF-Technik bei der Meßdatenübertragung innerhalb des Rezipienten 22 angebracht und über eine isolierte Vakuumdurchführung 23 aus dem Rezipienten herausgeführt. Die Einheit zur Aufbereitung der empfangenen telemetrischen Daten, der Empfänger 29, befindet sich außerhalb der Anlage (22). Die Meßdaten können dann als digitale oder analoge Signale zur Auswertung vorliegen. Wenn die Meßdaten digital vorliegen, können sie direkt von einem Computer 30 übernommen werden, der die sofortige Auswertung übernimmt und die Korrekturen für die einzelnen Ätzparameter berechnet und die Ätzparameter entsprechend ändert.

In dem in Figur 6 dargestellten Blockdiagramm über den Meßablauf gelten folgende Bezugszeichen:

1, 2 = abzutragende Schicht auf einem isolierenden Substrat,
25 = Widerstandsmessung,
26 = Umsetzer (PCM-Modulator),
27 = Sender,
28 = Stromversorgung,
21 = Empfangsantenne,
23 = isolierte Vakuumdurchführung zur Antenne,
29 = Empfänger,
30 = Computer.

Der einfache Pfeil 31 in Figur 6 kennzeichnet den Vakuumanschluß des Rezipienten 22, der Doppelpfeil 32 die angebaute Schleusenkammer.

## Ansprüche

1. Verfahren zur Steuerung und Kontrolle von durch im Plasma aktivierten Ionen, Radikale und/oder neutrale Teilchen bewirkten Ätzprozessen, wie sie insbesondere bei der Strukturierung von für höchstintegrierte Halbleiterschaltungen verwendete elektrisch leitende Dünnschichten (1,11) mit Photolackmaskierung (3,13) verwendet werden, durch Bestimmung der Ätzrate und des Endpunktes der auf einem Substrat (2) befindlichen zu ätzenden Schicht (1, 11) während des Materialabtrags im Plasma unter Verwendung eines Referenzsubstrates (1, 2) mit niederohmigen Kontakten (4) und Messung des elektrischen Widerstandes in Abhängigkeit von der Schichtdicke, bei dem als Ätzreaktor ein evakuierter (31) Rezipient (22) mit einer evakuierbaren Schleusenkammer (32) verwendet wird, der die zu ätzenden Substrate (1, 2) tragende Substrathalter (7, 17) beweglich ausgebildet ist, die Meßdaten berührungsfrei durch elektromagnetische Strahlung im Pulscodemodulationsverfahren (PCM-Verfahren) übertragen werden, wobei ein telemetrisches Meßsystem (18) verwendet wird, welches als unabhängige Einheit an dem beweglichen Substrathalter (7, 17) montiert ist, und bei dem ein Referenzsubstrat verwendet wird, welches entsprechend der Größe der in der leitenden Schicht (1, 11) zu strukturierenden Bereiche unterschiedlich große Photolackmaskierungsbereiche (3, 13) enthält, die elektrisch vermessen werden, so daß die Ätzrate und die Schichtdickenabnahme d aus dem zeitlichen Verlauf der Widerstandszunahme des Flächenwiderstandes $R_F$ kontrolliert und damit der Endpunkt der Ätzung bestimmt werden kann.

## Claims

1. Method for controlling and supervising etching processes effected by ions, radicals and/or neutral particles activated in a plasma, such as are used in particular in the structuring of electrically conductive thin films (1, 11) with photoresist masking (3, 13) used for highly integrated semi-conductor circuits, by determining the etching rate and the end point of the layer (1, 11) to be etched, which is situated on a substrate (2) during the material erosion in the plasma using a reference substrate (1, 2) with low-impedance contacts (4) and by measuring the electrical resistance as a function of the layer thickness, in which an evacuated (31) chamber (22) having an evacuable lock chamber (32) is used as etching reactor, the substrate holder (7, 17) bearing the substrates (1, 2) to be etched is of movable design, and the measuring data are transmitted in a contactless manner by means of electromagnetic radiation using the pulse code modulation process (PCM process), a telemetrio measuring system (18) being used which is mounted as an independent unit on the movable substrate holder (7, 17), and in which a reference substrate is used which contains photoresist masking regions (3, 13) of different sizes corresponding to the size of the regions to be structured in the conductive layer (1, 11), said photoresist masking regions being electrically measured, so that the etching rate and the layer thickness reduction d can be supervised on the basis of the variation with time of the resistance increase of the surface resistance $R_F$ and thus the end point of the etching can be determined.

## Revendications

1. Procédé pour commander et contrôler des processus de corrosion à l'aide d'ions, de radicaux et/ou de particules neutres, activés dans un plasma, du type utilisé notamment lors de la structuration de couches minces électriquement conductrices (1,11), utilisées pour des circuits à semiconducteurs à très haute densité d'intégration, avec un masquage (3,13) à l'aide d'une laque photosensible, par détermination de la vitesse de corrosion et de l'instant final de corrosion de la couche (1,11), qui doit être corrodée, située sur un substrat (2), pendant l'enlèvement de matière dans le plasma, moyennant l'utilisation d'un substrat de référence (1,2) possédant des contacts de faible valeur ohmique (4), et par mesure la résistance électrique en fonction de l'épaisseur de couche, et selon lequel on utilise, en tant que réacteur pour la corrosion, un récipient (22), dans lequel un vide est établi (31) et qui comporte une chambre à sas (32), dans laquelle un vide peut être établi, le porte-substrats (7,17) portant les substrats (1,2) devant être corrodés est agencé de manière à être mobile, les données de mesure sont transmises, sans contact, au moyen d'un rayonnement électromagnétique selon le procédé de modulation par impulsions codées (procédé MIC), pour lequel on utilise un système de mesure télémétrique (18) qui est monté, sous la forme d'une unité indépendante, sur le porte-substrats mobile (7,17), et selon lequel on utilise un substrat de référence, qui contient des zones (3,13) de masquage formées d'une laque photosensible, qui possèdent des dimensions différentes en fonction des dimensions des zones devant être structurées dans la couche conductrice (1,11), et qui sont dimensionnées du point de vue électrique de sorte que la vitesse de corrosion et la réduction d de l'épaisseur de couche puissent être contrôlées à partir de la variation dans le temps de l'accroissement de la résistance superficielle ($R_F$) et que, par conséquent, l'instant final de la corrosion peut être déterminé.

FIG 1

FIG 2

FIG 4

FIG 3

FIG 5

FIG 6